Europäisches Patentamt

European Patent Office

Office européen des brevets

(11) Veröffentlichungsnummer: **0 418 905 A2**

# EUROPÄISCHE PATENTANMELDUNG

(21) Anmeldenummer: 90118157.8

(22) Anmeldetag: 21.09.90

(51) Int. Cl.5: **C23C 14/06, C23C 14/16, C23C 14/22, C23C 14/32, C23C 14/48, C23C 14/58**

(30) Priorität: 22.09.89 DE 3931565

(43) Veröffentlichungstag der Anmeldung:
27.03.91 Patentblatt 91/13

(84) Benannte Vertragsstaaten:
DE ES FR GB IT NL

(71) Anmelder: **DORNIER LUFTFAHRT GMBH**
**Postfach 3**
**W-8031 Wessling/Oberpfaffenhofen(DE)**

(72) Erfinder: **Holbein, Reinhold, Dipl.-Ing.**
**Paracelsusstrasse 11**
**W-7778 Markdorf(DE)**
Erfinder: **Wolf, Gerhard, Prof. Dr.**
**Rudolf-Krehl-Strasse 31a**
**W-6900 Heidelberg(DE)**

(74) Vertreter: **Landsmann, Ralf, Dipl.-Ing.**
**c/o DORNIER GMBH Postfach 1420**
**W-7990 Friedrichshafen 1(DE)**

(54) Korrosions- und reibbeständige Beschichtungen.

(57) Die Erfindung beschreibt ein Verfahren zur Herstellung von Schichten auf Bauteilen aus Stahl-, Titan-, Titanlegierungs- oder Kupferlegierungswerkstoffen bei dem das Schichtmaterial durch eine Kombination aus einem PVD-Aufdampfverfahren und einem Beschuß nach dem Ionen-Implantationsverfahren aufgetragen wird unter Verwendung eines gerichteten, in einer Ionenquelle erzeugten Ionenstrahls.

EP 0 418 905 A2

## KORROSIONS- UND REIBBESTÄNDIGE BESCHICHTUNGEN

Die Erfindung betrifft Bein Verfahren zur Beschichtung von Bauteilen.

Für Stahlteile, insbesondere des Flugzeugbaus, werden Kadmiumbeschichtungen als Schutzschicht eingesetzt.

Zahlreiche Korrosionsschäden an den Stahlbauteilen und die in zunehmendem Maße praktizierte notwendige Reduzierung von Kadmium wegen dessen Umweltschädlichkeit erfordern neue Schutzbeschichtungen insbesondere für fliegendes Gerät.

Als Alternativen können Aluminiumbeschichtungen in Frage kommen, doch sind die fehlende kathodischen Schutzwirkung in Kondenswasser und die ungenügende Reibcharakteristik von großem Nachteil. Aluminiumbeschichtungen lassen sich nicht anwenden für mehrmals zu lösende Verbindungselemente und bieten eine besondere Anfälligkeit für Reibkorrosion.

Besonders stark kommt die Thematik der Schutzbeschichtungen bei Titanbasiswerkstoffen und rostfreien Stählen zum Tragen. Im Flugzeugbau sind für derartige Titan-Verbindungselemente Schutzschichten gegen galvanische Kontaktkorrosion erforderlich, um im Zusammenbau mit Aluminium-Strukturen Korrosionsschäden zu unterbinden. Dafür ist bisher keine zufriedenstellende Beschichtung verfügbar.

Derzeit verwendeter Beschichtungen, sowohl galvanische als auch durch Verdampfung aufgetragene Beschichtungen, leiden unter einer unzureichenden Haftfestigkeit auf dem Trägerwerkstoff. Bei galvanischen Prozessen ist deshalb die Abscheidung einer ca. 1 $\mu$m dicken Nickelschicht erforderlich, was allerdings eine gewisse Wasserstoffversprödung bewirken kann.

Der Erfindung liegt die Aufgabe zugrunde, bestehende Nachteile bei der Beschichtung von Werkstoffen zu beseitigen.

Die Aufgabe wird durch das Verfahren nach Anspruch 1 gelöst.

Erfindungsgemäß wird zur Erzeugung von Beschichtungen ein Verfahren der ionenstrahlgestützten Bedampfung vorgeschlagen. Es beruht auf der gleichzeitigen oder alternierenden Aufdampfung eines Elements oder einer Legierung und der Ionenbestrahlung des Substrats und der aufwachsenden Schicht, bevorzugt in einer Vorrichtung.

Unter PVD im Sinne der Erfindung ist zu verstehen: Abscheidung von Schichten aus der Gasphase auf einem Substrat, das entweder auf Erdpotential liegt, oder eine positive bzw. negative Potentialdifferenz gegenüber der Umgebung besitzt. Die Abscheidung findet entweder im Hochvakuum (p < 10$^{-5}$ mbar) statt oder bei vermindertem Druck(< 10$^{-3}$ mbar) in einer reaktiven Restgasatmosphäre (Stickstoff, Sauerstoff, Kohlenwasserstoff usw.). Die Erzeugung der Gasphase geschieht entweder durch thermisches Verdampfen oder Elektronenstrahlverdampfen oder Einlassen von bereits gasförmigen Produkten durch ein Ventil.

Vor und/oder während und/oder nach der Abscheidung wird das Substrat mit Ionen aus einer Ionenquelle, das heißt mit einem gerichteten Ionenstrahl beschossen.

Der Ionenbeschuß kann zur Substratreinigung bereits vor dem Aufdampfen beginnen und zur Erzielung spezieller Effekte, beispielsweise der Oberflächennitrierung erst nach dem Aufdampfen enden. Ebenso ist auch eine konsekutive Folge: Ionenbeschuß... Aufdampfen... Ionenbeschuß... etc. möglich. Der Ionenbeschuß kann entweder mit inerten Ionen, beispielsweise Edelgasionen oder Eigenionen von Schicht oder Substrat, erfolgen, um Schichten aus Elementen zu erhalten oder mit reaktiven Ionen wie Stickstoff oder Sauerstoff, die dann in die Schicht eingelagert werden und zur Bildung von Nitriden, Oxiden etc. führen.

Eine Besonderheit der Erfindung liegt also darin, ein simultanes Aufdampf-und Ionenstrahlverfahren auf die Herstellung von Korrosionsschutzschichten einer Dicke bis 10 $\mu$m anzuwenden. Insbesondere Legierungsschichten, die eine kathodische Schutzwirkung zeigen, und Schichten wie CrN und AlN, die die Reibungskorrosion herabsetzen. Schließlich eine Kombination von Metall bzw. Legierungsschichten mit reibungsarmen Schichten Substrat/Al/AlN, Substrat/Al-Legierung/CrN, um das Korrosionsverhalten zu verbessern.

Das Verfahren unterscheidet sich von den plasmagestützten Verfahren wie Plasma-CVD (CVD = Chemical Vapor Deposition) oder Ionenplattieren dadurch, daß die Ionen als Strahl gerichtet angewendet werden. Intensität und Energie der Ionen sowie die Ionen/Atom-Auftreffrate auf das Substrat sind ge nau kontrollierbar und in weiten Grenzen variierbar. Dadurch lassen sich Schichteigenschaften wie Dichte, Porosität, Adhäsion oder Eigenspannungen stark beeinflussen. Weitere Unterschiede zu den obengenannten Verfahren sind die niedrige Substrattemperatur von $\leq$ 200$^{\circ}$ C und der niedrige Arbeitsdruck von $\leq$10$^{-5}$ Torr in der Beschichtungskammer.

Zum Aufdampfen wird ein Elektronenstrahlverdampfer, wobei eine Zweitiegelversion für Legierungen vorgesehen werden kann, oder ein thermischer Verdampfer verwendet, und zum Ionenbeschuß Ionenquellen im Energiebereich 0.5 - 50 keV mit Strahlströmen von > 1 mA.

Das Prinzip der ionenstrahlgestützten Beschichtung beruht darauf, daß Atome im Dampfzustand und inerte Ionen gleichzeitig auf die Oberfläche des zu beschichtenden Materials auftreffen, so daß es möglich ist, dickere Schichten als 1 μm zu erzeugen. An der Grenzfläche zwischen Beschichtung und Grundwerkstoff kommt es dadurch zu einer Mischung der beiden Materialien. Das erfindungsgemäße Verfahren verbindet das reine Aufdampfen von Schichten aus Elementen oder Legierungen auf ein Grundmaterial mit der Ionen-Implantationstechnik.

Hieraus ergeben sich mehrere Möglichkeiten der Beschichtung:
- Erzeugung dünner Schichten bis 1 μm durch gleichzeitiges Verdampfen und Beschießen, während dickere Schichten durch anschließendes Aufdampfen erzielt werden.
- Verdampfen und gleichzeitiges Beschießen mit reaktiven Ionen, was zur Bildung von Metalloxiden, -nitriden, -carbiden etc. führen kann.
- Verdampfen und gleichzeitiges Beschießen mit Edelgasionen, gefolgt von einem Beschuß mit reaktiven Ionen, was z.B. zu einer Schichtfolge Substrat/Al/AlN führen kann.
- Verdampfen und gleichzeitiges Beschießen mit Edelgas- oder reaktiven Ionen mit einem Wechsel des Verdampfungselements, was z.B. zu einer Schichtfolge Substrat/Ti/C führen kann.
- Durch Veränderung der Aufdampf- und Einschußrate sowie der Energie der Ionen lassen sich die Eigenschaften der Beschichtung variieren. Besonders interessant sind in diesem Zusammenhang die elektrochemischen Eigenschaften, die Leitfähigkeit, Zugfestigkeit, Haftfestigkeit und die Struktur der Beschichtung. Besonders die Haftfestigkeit sich kaum mischender Komponenten, beispielsweise von Aluminium und Eisen, läßt sich durch diese Technik wesentlich verbessern.

Ein Problem ergibt sich durch den hohen Ionenstrom, der auf die Probe trifft, weshalb man einen erheblichen Teil der aufgedampften Atome durch das Sputtern wieder verliert. Wenn immer möglich dient daher die unter Beschuß aufgebrachte Schicht nur als Zwischenschicht und wird anschließend durch reines Aufdampfen verdickt.

Es werden verschiedene Beschichtungen vorgeschlagen.

Als Korrosionsschutzschicht, die auch in Kondenswasser eine kathodische Schutzwirkung aufweist, werden beispielsweise auf einem schweißbaren Chrom-Molybdän-Vanadium-Vergütungsstahl Al-Legierungen aufgebracht. Als Verschleißschutzschichten können Grundwerkstoffe mit den Beschichtungen Chrom-Stickstoff oder amorpher Kohlenstoff beschichtet werden.

In chloridhaltigen Medien wirkt Aluminium und Kadmium als kathodischer Schutz. In chloridfreien Medien kann das Aluminium eine passive Oxidschicht ausbilden, während Kadmium als kathodischer Schutz wirkt. Eine Beschichtung aus Aluminium und Kadmium kann wie folgt aufgebracht werden:

1) Aufdampfen des Aluminiums + Argonionen-Beschuß
2) Verstärkung der Schicht durch reines Aluminium
3) Aufdampfen des Kadmiums mit gleichzeitiger Durchmischung mittels Argonionen.

Alle drei Schritt laufen in der gleichen Apparatur ohne Prozeßunterbrechung ab.

Diese Verfahrensweise begründet die erzielbaren, günstigen Haftungseigenschaften.
Die Schichtfolge kann so variiert werden, daß einerseits Schichten erzeugt werden, bei denen einer Kadmium-Grundschicht eine Aluminum-Deckschicht überlagert wird, oder andererseits Aluminium und Kadmium gleichzeitig aufgedampft werden, um eine legierungsartige Schicht zu bilden.
Alternativ zu Kadmium kann auch Lithium oder Magnesium als Schichtbestandteil bei gleicher Verfahrensweise wie bei Aluminium-Kadmium verwendet werden.

Eine weitere Beschichtung, die als Deckschicht auf eine Korrosionsschutzgrundschicht aufzubringen ist, besteht aus nahezu reinem Kohlenstoff. Sie ist chemisch inert und normale Lösemittel, Säuren und Laugen greifen die Schicht wenig an. Eine der wichtigsten Eigenschaften dieser Schicht ist ihre große Härte. Diese liegt über 3000 HV (Vickers-Härte). Trotz dieser hohen Härte besitzt die Schicht noch elastische Eigenschaften.

Eine weitere ungewöhnliche Eigenschaft der Kohlenstoffschicht ist der sehr niedrige Reibungskoeffizient. Ungeschmiert sind gegen Stahl selbst im Vakuum Reibungskoeffizienten von $\mu = 0.02$ meßbar. Am günstigsten ist eine Reibpaarung Schicht-Schicht, die sich als tribologisch wirksame Veredlung besonders eignet.
Anders als bei Schichten aus Trockenschmierstoffen, wie beispielsweise Molybdänsulfid, kann bei gleitender Beanspruchung von diamantartigen Kohlenstoffschichten nahezu kein Verschleiß der Schicht festgestellt werden.

Als weiteres kommt z.B. als Deckschicht noch eine Chrom-Stickstoffbeschichtung in Betracht, die wie die Kohlenstoffbeschichtung zu den Hartstoffbeschichtungen zählt. Die Schicht zeichnet sich durch gute Gleit- und Ermüdungseigenschaften aus und besitzt eine Härte von über 3000 HV.

Durch die Verwendung des erfindungsgemäßen ionenstrahlunterstützten Aufdampfens wird die Bildung von legierten Schutzschichten ermöglicht. Durch die Einbringung geeigneter Legierungselemente, beispielsweise Magnesium oder Lithium, werden die Reibcharakteristik und das Korrosionsschutzprofil derart verändert, daß die Passivität des Aluminiumüberzugs in Kondenswasser aufgehoben und die Reibwerte reduziert werden.

Der typische Verfahrensablauf läßt sich folgendermaßen charakterisieren:

1. mechanische und chemische Vorreinigung des Substrats

2. Ionenbeschuß des Substrats zur weiteren Reinigung

3. Einschalten des Verdampfers zum Aufbringen des Metalls oder der Legierung

4. Gegebenenfalls Variation der Ionenenergie oder Intensität während des Prozesses

5. Gegebenenfalls Wechsel des Tiegels zur Verdampfung einer zweiten Komponente während des Prozesses

6. Gegebenenfalls Wechsel der Ionensorte während des Prozesses

7. Ausschalten des Verdampfers

8. Ausschalten der Ionenquelle, gegebenenfalls nach einer längeren Nachbestrahlung der Schicht.

Neben der kathodischen Schutzwirkung in chloridfreien Medien ergibt sich bei verschiedenen Schichten auch der Vorteil der Verbesserung der Reibwerte und der Schichthaftung auf den Basiswerkstoffen.

Auch Bauteile aus Kupferlegierungen können erfindungsgemäß beschichtet werden.

Eine Vorrichung zur Durchführung der Erfindung wird anhand einer Figur erläutert.

Die Fig. zeigt eine Anlage für die ionenstrahlgestützte Beschichtung, enthaltend eine Verdampferquelle für die Schichtabscheidung und eine Ionenquelle für die Schichtbestrahlung mit folgenden Bauteilen:

A Ionenstrommessung durch eine Faradaytasse

B bewegliche Blende

C Schichtdickenmesser

D Substrat

E Reaktivgaseinlaß mit Ringdüse

F gekühlter drehbarer Substrathalter

G Ionenstrommeßgerät

H Elektronenstrahlverdampfer

I Glimmelektrode

K Ionenstrahl

L Defokussierelektrode

M Anschluß zur Vakuumpumpe

Der typische Verfahrensablauf:

1. Mechanische und chemische Vorreinigung des Substrats durch Polieren, Beizen, Elektropolieren und ähnliche Prozeduren.

2. Einschleußen des Substrats in die Vakuumkammer. Abpumpen auf den gewünschten Enddruck.

3. Einschalten der Ionenquelle und Ionenbeschuß des Substrats zur Reinigung durch Oberflächenzerstäubung.

4. Einschalten des Verdampfers zum Verdampfen des Metalls (Eintiegelverdampfen) oder der Legierung (Zweitiegelverdampfen).

5. Wahl eines für die Aufgabenstellung geeigneten Ionen/Atomverhältnisses durch Modulation der Ionenquelle. Aufbringen der Schicht unter Ionenbeschuß. Ionenquelle hier z.B. ohne magnetische Ionentrennung. Energien hier zwischen 0,5 und 50 keV.

6. Gegebenenfalls Abschalten der Ionenquelle und Schichtverdickung durch Aufdampfen ohne Ionenbeschuß.

7. Gegebenenfalls Ausschalten des Verdampfers bei laufender Ionenquelle zur Nachbestrahlung der Schicht.

8. Gegebenenfalls kann die Ionenenergie oder das Ionen/Atom verhältnis während der Schichterzeugung verändert werden. Ersteres verändert Haftung und Defektstruktur der Schicht, letzteres Eigenspannung und Defektstruktur, bei Verbindungsschichten auch die stöchiometrische Zusammensetzung.

9. Bei Schichten aus Elementen oder Legierungen werden in der Regel Edelgasionen zum Beschuß verwendet. Bei Schichten aus Verbindungen (TiN, TiC) entweder Edelgasionen in reaktiver Restgasatmosphäre oder reaktive Ionen wie $N^+$, $C^+$, $O^+$ usw.

10. Gegebenenfalls Wechsel des Verdampfungsmaterials während des Prozesses. Es entstehen Mehrkomponentenschichten bzw. Schichtfolgen, z.B. Al/Mg/Al/Mg...

11. Gegebenenfalls Wechsel der Ionensorte oder des Reaktivgases während des Prozesses. Es entstehen Schichtfolgen, z.B. Ti/TiC/C oder TiN/TiC/TiN...

12. Die Aufdampfraten werden mit einem Schwingquarz, optischem System oder massenspektroskopisch gemessen, die Ionenströme über Faradaybecher und die Temperatur über Thermoelemente am Substrat bzw. Substrathalter. Wasserkühlung des Substrats ist möglich.

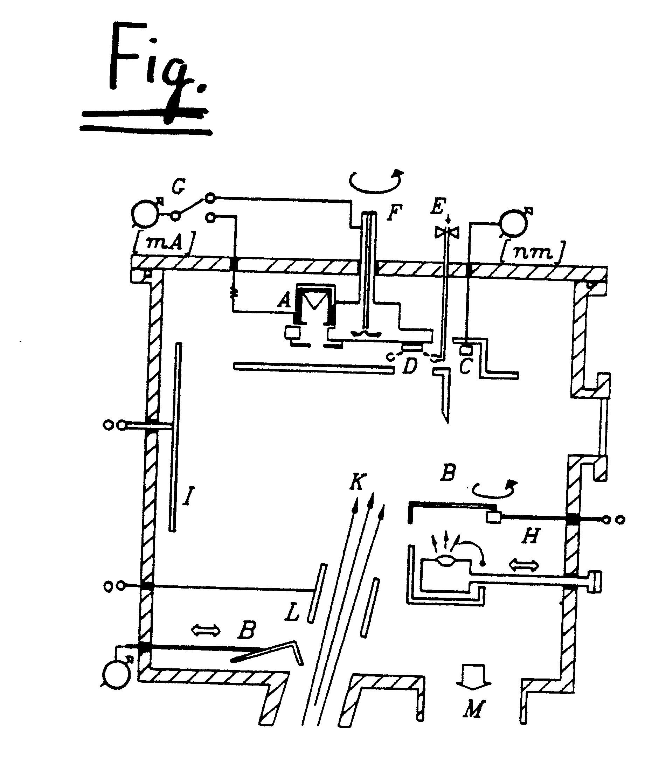

**Ansprüche**

1. Verfahren zur Herstellung von Schichten auf Bauteilen aus Stahl-, Titan-, Titanlegierungs- oder Kupferlegierungswerkstoffen, **dadurch gekennzeichnet**, daß das Schichtmaterial durch eine Kombination aus einem PVD-Aufdampfverfahren und einem Beschuß nach dem Ionen-Implantationsverfahren aufgetragen wird unter Verwendung eines gerichteten, in einer Ionenquelle erzeugten Ionenstrahls.

2. Verfahren nach Anspruch 1, **dadurch gekennzeichnet**, daß Bestrahlung und Aufdampfprozess gleichzeitig erfolgen.

3. Verfahren nach Anspruch 1, **dadurch gekennzeichnet**, daß die Bestrahlung nachfolgend auf den Aufdampfprozess, insbesondere ohne Prozessunterbrechung, erfolgt.

4. Verfahren nach Ansprüchen 2 oder 3, **dadurch gekennzeichnet,** daß nach der Bestrahlung der Aufdampfprozess (ohne Prozessunterbrechung) fortgesetzt wird.

5. Verfahren nach einem der vorherigen Ansprüche, **dadurch gekennzeichnet,** daß durch Veränderung der Ionenenergie, Ionenintensität und des Verhältnisses der Ionen- zur Atomauftreffrate die Eigenschaften der Schicht variiert werden.

6. Verfahren nach einem der Ansprüche 1 bis 5, **dadurch gekennzeichnet,** daß Reinaluminium und Magnesium gleichzeitig auf Titan legierungen, Stahlwerkstoffen oder Kupferlegierungen aufgedampft werden unter gleichzeitigem und/oder nachfolgendem Beschuß von Edelgas- oder Stickstoffionen.

7. Verfahren nach einem der Ansprüche 1 bis 5, **dadurch gekennzeichnet,** daß Reinaluminium und Lithium gleichzeitig auf Titanlegierungen, Stahlwerkstoffen oder Kupferlegierungen aufgedampft werden unter gleichzeitigem und/oder nachfolgendem Beschuß von Edelgas- oder Stickstoffionen.

8. Verfahren nach einem der Ansprüche 1 bis 5, **dadurch gekennzeichnet,** daß Reinaluminium und Silicium gleichzeitig auf Titanlegierungen, Stahlwerkstoffen oder Kupferlegierungen aufgedampft werden unter gleichzeitigem und/oder nachfolgendem Beschuß von Edelgas- oder Stickstoffionen.

9. Verfahren nach einem der Ansprüche 1 bis 5, **dadurch gekennzeichnet,** daß Reinaluminium und Kadmium gleichzeitig auf Titanlegierungen, Stahlwerkstoffen oder Kupferlegierungen aufgedampft werden unter gleichzeitigem und/oder nachfolgendem Beschuß von Edelgas- oder Stickstoffionen.

10. Verfahren nach einem der Ansprüche 1 bis 5, **dadurch gekennzeichnet,** daß Reinaluminium und Zink gleichzeitig auf Titanlegierungen, Stahlwerkstoffen oder Kupferlegierungen aufgedampft werden unter gleichzeitigem und/oder nachfolgendem Beschuß von Edelgas-oder Stickstoffionen.

11. Verfahren nach einem der Ansprüche 1 bis 5, **dadurch gekennzeichnet,** daß Chrom oder Bor auf Titanlegierungen aufgedampft werden bei gleichzeitigem oder nachfolgendem Beschuß mit Edelgas- oder Stickstoffionen.

12. Verfahren nach einem der Ansprüche 1 bis 5, **dadurch gekennzeichnet,** daß ein Schichtmaterial aus Kohlenstoff verwendet wird.

13. Beschichtung für Stahl-, Titan- oder Titanlegierungswerkstoffe, **gekennzeichnet** durch eine Legierung aus Aluminium und Magnesium, Lithium, Silicium, Kadmium oder Zink mit einem Reibwert $\mu \leq 0.12$.

14. Beschichtung für Stahl-, Titan- oder Titanlegierungswerkstoffe, **gekennzeichnet** durch eine Titan-Kohlenstoffschichtfolge und eine Härte von $\geq 3000$ HV und einem Reibwert $\mu < 0,12$.

15. Verfahren nach einem der Ansprüche 1 bis 10, **dadurch gekennzeichnet,** daß unmittelbar auf die genannte Beschichtung eine Beschichtung mit Chrom erfolgt.

16. Verfahren nach einem der Ansprüche 1 bis 5, **dadurch gekennzeichnet,** daß Ti und Kohlenstoff abwechselnd oder nacheinander aufgedampft werden unter gleichzeitigem und/oder nachfolgendem Beschuß von Edelgas- oder Stickstoffionen.

Fig. 7